(19) **Europäisches Patentamt**
**European Patent Office**
**Office européen des brevets**

(11) **EP 2 924 695 A1**

(12) **EUROPEAN PATENT APPLICATION**
published in accordance with Art. 153(4) EPC

(43) Date of publication:
**30.09.2015 Bulletin 2015/40**

(21) Application number: **12888811.2**

(22) Date of filing: **21.11.2012**

(51) Int Cl.:
**H01B 5/14** (2006.01)     **G01L 1/14** (2006.01)
**G01L 5/00** (2006.01)     **H04R 19/00** (2006.01)
**H05K 1/09** (2006.01)

(86) International application number:
**PCT/JP2012/080158**

(87) International publication number:
**WO 2014/080470 (30.05.2014 Gazette 2014/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Sumitomo Riko Company Limited**
**Komaki-shi, Aichi 485-8550 (JP)**

(72) Inventors:
• **TAGUCHI, Yutaro**
  **Komaki-shi**
  **Aichi 485-8550 (JP)**
• **KAWAGUCHI, Junya**
  **Komaki-shi**
  **Aichi 485-8550 (JP)**

• **KOBAYASHI, Jun**
  **Komaki-shi**
  **Aichi 485-8550 (JP)**
• **YOSHIKAWA, Hitoshi**
  **Komaki-shi**
  **Aichi 485-8550 (JP)**
• **YOSHIKAWA, Takeaki**
  **Komaki-shi**
  **Aichi 485-8550 (JP)**

(74) Representative: **Müller-Boré & Partner**
**Patentanwälte PartG mbB**
**Friedenheimer Brücke 21**
**80639 München (DE)**

(54) **FLEXIBLE CONDUCTIVE MEMBER AND TRANSDUCER USING SAME**

(57) A flexible conductive member of the present invention includes an elastic substrate (31) and a plurality of conductive layers (32, 33) arranged on a surface of the substrate (31) in at least one of a stacked manner and a parallel manner. The conductive layers (32, 33) include: a first conductive layer (33) including a highly conductive material that contains an elastomer and a conductive agent and has a volume resistivity of $5 \times 10^{-2}$ $\Omega \cdot$cm or less in an unextended condition; and a second conductive layer (32) including a highly extensible conductive material that has a volume resistivity in an unextended condition larger than the volume resistivity of the highly conductive material in an unextended condition, contains an elastomer and a conductive agent, and has a change in volume resistivity at an elongation of 50% relative to an unextended condition of 10 times or less.

[FIG. 4]

EP 2 924 695 A1

**Description**

TECHNICAL FIELD

The present invention relates to a flexible conductive member suitably used for elastic electrodes, wirings, and the like.

BACKGROUND ART

Highly flexible, compact and lightweight transducers have been developed by using polymer materials such as elastomers. Such a transducer includes a dielectric layer made of an elastomer between electrodes. For example, in an actuator, members are driven by extension and contraction of the dielectric layer depending on an applied voltage between the electrodes. In a capacitance sensor, a change in capacitance between the electrodes due to deformation of the dielectric layer is detected. On this account, in a flexible transducer, electrodes and wirings that connect the electrodes to an electric circuit are required to have elasticity so as to follow deformation of the dielectric layer. In addition, wirings connecting a transducer to an electric circuit and conductive members used in a connection part that is connected to an electric circuit are also required to have elasticity. As materials of the elastic electrodes and wirings, a conductive material prepared by adding a conductive agent in an elastomer is used (for example, see Patent Documents 1 and 2).

Related Art Documents

Patent Documents

Patent Document 1: Japanese Patent Application Publication No. 2010-153821 (JP 2010-153821 A)
Patent Document 2: Japanese Patent Application Publication No. 2011-75322 (JP 2011-75322 A)
Patent Document 3: Japanese Patent Application Publication No. 2005-317638 (JP 2005-317638 A)
Patent Document 4: Japanese Patent Application Publication No. 6-194680 (JP 6-194680 A)

SUMMARY OF THE INVENTION

Problem to be Solved by the Invention

Wiring materials contain silver powder as the conductive agent in order to reduce electrical resistance. However, metal powders such as silver powder are less likely to aggregate. In a wiring material containing such a metal powder, conductive pathways are difficult to be formed as compared with a wiring material containing an electrically conductive carbon. In order to provide an intended electric conductivity, a large amount of the metal powder is required to be added to an elastomer. A conductive material containing a larger amount of the metal powder has a higher elastic modulus and a lower flexibility. Such a conductive material has lower following performance with respect to the deformation of a dielectric layer. In addition, stress is concentrated on the interface between the elastomer and the metal powder when the conductive material is extended, and thus cracks are readily generated. On this account, the electrical resistance markedly increases when the conductive material is extended.

In contrast, a conductive material prepared by adding an electrically conductive carbon to an elastomer has a smaller elastic modulus and excellent flexibility as compared with the conductive material containing a metal powder. Such a conductive material thus has an electrical resistance that is less likely to increase even when extended. However, the electrically conductive carbon has a comparatively large specific resistance of about 0.1 to 1 $\Omega \cdot$cm. A wiring formed from the conductive material that is prepared by adding such an electrically conductive carbon to an elastomer has a larger electrical resistance and thus is difficult to achieve an intended electric conductivity. It is therefore difficult to achieve both the elasticity and the electric conductivity by using a single conductive material.

In view of the above circumstances, it is an object of the present invention to provide a flexible conductive member that is elastic and excellent in electric conductivity and has an electrical resistance that is less likely to increase even when extension and contraction are repeated. Another object of the present invention is to provide a flexible transducer having excellent durability by using the flexible conductive member as wirings or other members.

Means for Solving the Problem

(1) In order to solve the problem, a flexible conductive member of the present invention is characterized by including an elastic substrate and a plurality of conductive layers arranged on a surface of the substrate in at least one of a stacked manner and a parallel manner. The conductive layers include: a first conductive layer including a highly conductive material that contains an elastomer and a conductive agent and has a volume resistivity of $5 \times 10^{-2}$ $\Omega \cdot$cm or less in an unextended condition; and a second conductive layer including a highly extensible conductive material that has a volume resistivity in an unextended condition larger than the volume resistivity of the highly conductive material in an unextended condition, contains an elastomer and a conductive agent, and has a change in volume resistivity at an elongation of 50% relative to an unextended condition of 10 times or less.

The flexible conductive member of the present invention includes at least two conductive layers arranged on the surface of an elastic substrate. One (first conductive layer) of the conductive layers includes a highly conductive material, and another (second conductive layer) includes a highly extensible conductive material. Each of the first conductive layer and the second conductive layer contains an elastomer as the base material. On this account, the first conductive layer and the second conductive layer can extend and contract together with the substrate. In the present specification, the elastomer includes crosslinked rubbers and thermoplastic elastomers.

The highly conductive material has a volume resistivity of $5 \times 10^{-2}$ $\Omega \cdot$cm or less in an unextended condition (natural condition). In other words, the first conductive layer has high electric conductivity. The highly extensible conductive material has a volume resistivity in an unextended condition larger than the volume resistivity of the highly conductive material in an unextended condition. However, the highly extensible conductive material has a change in volume resistivity at an elongation of 50% relative to an unextended condition of 10 times or less. That is, the second conductive layer has an electric conductivity that is less likely to decrease even when extended. In the flexible conductive member of the present invention, the plurality of conductive layers including these two conductive layers are arranged on the substrate in a stacked manner, in a parallel manner, or in a stacked and parallel manner. Accordingly, even when the second conductive layer has a large volume resistivity in a natural condition, the electrical resistance can be kept small because electricity passes mainly through the first conductive layer. At the time of extension, even when the volume resistivity of the first conductive layer increases, the electrical resistance can be kept small because electricity passes mainly through the second conductive layer.

Thus, the flexible conductive member of the present invention can maintain an intended electric conductivity both in a natural condition and an extended condition because an advantageous conductive pathway can be selected in accordance with the conditions. The flexible conductive member thus has an electrical resistance that is less likely to increase even when extension and contraction are repeated. When stacked, the conductive layers provide reinforcing effect to improve the durability against extension and contraction.

Patent Document 3 describes a wiring board including an insulating substrate, a carbon circuit printed on the insulating substrate, and a wiring circuit made of a silver paste and printed on the carbon circuit. However, the wiring boards described in Patent Document 3 are wiring boards such as printed wiring boards and mounting circuit substrates, and no elasticity is required of such wiring boards. Therefore, no elasticity is required of either the carbon circuit or the wiring circuit. The carbon circuit simply plays a roll of suppressing migration of the silver wiring. Patent Document 3 does not discuss the increase in the electrical resistance of the wiring extended. Patent Document 4 describes a two-layered conductive layer including a carbon paste and a silver paste as a conductive layer for reinforcing an ITO film. However, no elasticity is required of the conductive layer. Thus, Patent Document 4 does not discuss the increase in the electrical resistance of the conductive layer extended.

(2) A transducer of the present invention is characterized by including the flexible conductive member in (1).

A transducer is an apparatus that converts a type of energy to another type of energy. The transducer is exemplified by transducers that perform the conversion between mechanical energy and electric energy, such as actuators, sensors, and power generation devices, and transducers that perform the conversion between acoustic energy and electric energy, such as speakers and microphones.

In the transducer of the present invention, the electrodes and the wirings can be formed of the flexible conductive member of the present invention. The electrodes and the wirings formed of the flexible conductive member of the present invention are elastic and have high electric conductivity in a natural condition and an extended condition. On this account, the transducer of the present invention has a performance that is less likely to deteriorate due to the electrodes or the wirings. The transducer of the present invention therefore has excellent durability.

BRIEF DESCRIPTION OF THE DRAWINGS

[FIG. 1] FIG. 1 is a perspective top view of a capacitance sensor as an embodiment of a transducer of the present invention.
[FIG. 2] FIG. 2 is an exploded sectional view taken along line II-II in FIG. 1.
[FIG. 3] FIG. 3 is an enlarged view of the area within frame III in FIG. 1.

[FIG. 4] FIG. 4 is a sectional view taken along line IV-IV in FIG. 3.
[FIG. 5] FIG. 5 is a sectional view taken along line V-V in FIG. 3.

Description of the Reference Numerals

1: capacitance sensor (transducer); 11: dielectric layer; 12: fused portion; 20: front sheet member; 21: front substrate 30: back sheet member; 31: back substrate; 32: second conductive layer; 33: first conductive layer; 34: protective layer; 35: reinforcement layer; 320: recess; 330: terminal 01X to 08X: front electrode; 01Y to 08Y: back electrode; 01x to 08x: front wiring; 200x: connection end; 01y to 08y: back wiring; 300y: connection end; A0101 to A0808: detection portion

MODES FOR CARRYING OUT THE INVENTION

First, an embodiment of a flexible conductive member of the present invention will be described. An embodiment of a transducer of the present invention will be described subsequently. The flexible conductive member and the transducer of the present invention are not limited to the embodiments below, and various modifications, improvements, and the like may be made thereto by a person skilled in the art without departing from the scope of the present invention.

<Flexible Conductive Member>

A flexible conductive member of the present invention includes an elastic substrate and a plurality of conductive layers arranged on a surface of the substrate in at least one of a stacked manner and a parallel manner.
The substrate is not specifically limited as long as it is elastic and a conductive layer can be formed thereon. Examples of the substrate include films of resins such as polyimide, polyethylene, polyethylene terephthalate (PET), and polyethylene naphthalate (PEN); elastomer sheets; and stretchable fabrics.
As the conductive layer, at least the first conductive layer and the second conductive layer described later are arranged. In addition to the first conductive layer and the second conductive layer, other conductive layers may be arranged. The conductive layers are arranged in a stacked manner, a parallel manner, or a combination manner of them. When arranged in parallel, the conductive layers may be in contact with each other or may not be in contact with each other. When not being in contact with each other, the conductive layers are connected electrically in parallel to each other. The flexible conductive member of the present invention may include a protective layer and the like for covering the conductive layers in addition to the conductive layers.
The first conductive layer, which is one of the conductive layers, includes a highly conductive material that contains an elastomer and a conductive agent and has a volume resistivity of $5 \times 10^{-2}$ $\Omega \cdot$cm or less in an unextended condition. In order to further improve the electric conductivity, the highly conductive material preferably has a volume resistivity of $1 \times 10^{-3}$ $\Omega \cdot$cm or less in an unextended condition.
The elastomer is not particularly limited. Preferred examples of the elastomer include urethane rubber, acrylic rubber, silicone rubber, ethylene-propylene copolymerized rubber, natural rubber, styrene-butadiene copolymerized rubber, acrylonitrile-butadiene copolymerized rubber, epichlorohydrin rubber, chlorosulfonated polyethylene, and chlorinated polyethylene.
In order to achieve a volume resistivity of $5 \times 10^{-2}$ $\Omega \cdot$cm or less in an unextended condition, the conductive agent is preferably powder of metal such as silver, gold, copper, nickel, rhodium, palladium, chromium, titanium, platinum, iron, or an alloy of them. A single metal powder may be used, or two or more metal powders may be used as a mixture. Among them, silver powder is preferred. The amount of the metal powder can be appropriately selected so as to achieve an intended volume resistivity. For example, the amount is preferably 200 parts by mass or more relative to 100 parts by mass of the elastomer. If containing a large amount of the metal powder, the first conductive layer has lower flexibility. The amount of the metal powder is thus preferably 500 parts by mass or less relative to 100 parts by mass of the elastomer.
The second conductive layer, which is the other of the conductive layers, includes a highly extensible conductive material that has a larger volume resistivity in an unextended condition than the volume resistivity of the highly conductive material in an unextended condition, contains an elastomer and a conductive agent, and has a change in volume resistivity at an elongation of 50% relative to an unextended condition of 10 times or less.
The elastomer may be the same as or different from the elastomer of the first conductive layer. The elastomer can be appropriately selected from the elastomers listed in the description of the first conductive layer.
The conductive agent is preferably an electrically conductive carbon powder such as carbon black, carbon nanotube, and graphite. The highly extensible conductive material has a larger volume resistivity in an unextended condition than the volume resistivity of the highly conductive material in an unextended condition. For example, the highly extensible conductive material preferably has a volume resistivity of $1 \times 10^{1}$ $\Omega \cdot$cm or less in an unextended condition. The difference between the volume resistivity of the highly conductive material in an unextended condition and the volume resistivity of the highly extensible conductive material in an unextended condition is preferably five digits or less. To achieve such a highly extensible conductive material, the type and the amount of the electrically conductive carbon powder can be appropriately adjusted. For example, the amount of the electrically conductive carbon powder is preferably 10 parts by mass or more relative to 100 parts by mass of the elastomer. If containing a large amount of the electrically conductive carbon powder, the highly extensible conductive material has lower flexibility. The amount of the electrically conductive carbon powder is thus preferably 100 parts by mass or less relative to 100 parts by mass of the elastomer.

The highly extensible conductive material has a smaller change in volume resistivity at an elongation of 50% relative to an unextended condition than the highly conductive material. The highly extensible conductive material has a volume resistivity that is less likely to increase even when extended. Specifically, the highly extensible conductive material has a change in volume resistivity at an elongation of 50% relative to an unextended condition of 10 times or less. In order to improve the flexibility and to improve the elasticity, the highly extensible conductive material preferably has an elastic modulus of 50 MPa or less.

As described above, the conductive layers are arranged in a stacked manner, a parallel manner, or a combination manner of them. To improve the durability against extension and contraction with the reinforcing effect of the conductive layers, the first conductive layer and the second conductive layer are preferably stacked. For example, when the first conductive layer contains a metal powder, and the second conductive layer contains an electrically conductive carbon powder, the first conductive layer can be reinforced by placing, on the first conductive layer, the second conductive layer containing the electrically conductive carbon powder that provides reinforcing effect.

For a laminate of the first conductive layer and the second conductive layer, an uneven interface increases the adhesion force between the layers. That is, conductive layers having a lamination surface with large surface roughness are less likely to delaminate due to anchor effect even when extension and contraction are repeated. In addition, in stacked conductive layers having a large adhesion force, a stress at the time of extension and contraction is transmitted to the whole conductive layers rather than to only one conductive layer, and thus the durability of the whole conductive layers is improved. To provide the adhesion improvement effect by the anchor effect, for example, the conductive layer arranged on the substrate preferably has a surface roughness of 1/200 or more the thickness of the conductive layer. In conductive layers having an excessively large unevenness, stress is more likely to be concentrated on concave portions (thin layer portions), and cracks may be generated. Thus, the conductive layer arranged on the substrate preferably has a surface roughness of twice or less the thickness of the conductive layer. For example, when the first conductive layer contains a metal powder, and the second conductive layer contains an electrically conductive carbon powder, the second conductive layer is more likely to have a larger surface roughness. In this case, in order to increase the adhesion force between the two layers, it is preferred that the second conductive layer be arranged on the surface of the substrate, and the first conductive layer be arranged on the surface of the second conductive layer.

In the present specification, a value calculated by the following method is used as the surface roughness of the conductive layer. First, a cross section of the conductive layers in the stacking direction is observed under a scanning electron microscope (SEM) to determine a base line of the interface of the conductive layers to be measured. Next, the total area (S1) of protrusions protruding from the base line and the total area (S2) of grooves cut to the base line are calculated. The surface roughness is calculated in accordance with Equation (1):

$$\text{Surface roughness} = (S1 + S2)/\text{length of base line} \qquad (1)$$

In the flexible conductive member of the present invention, the conductive layers may be formed by any method. A previously formed conductive layer may be affixed to the substrate, or a conductive paint may be printed. The printing method facilitates formation of long conductive layers, fine conductive layers, and thin film-like conductive layers. Examples of the printing method include inkjet printing, flexo printing, gravure printing, screen printing, pad printing, and lithography. Among them, screen printing is preferred because it can easily adjust the coating thickness and achieve high dimensional accuracy.

For forming the conductive layer by printing, it is desired to consider the compatibility between the solvents contained in a conductive paint and the polymers contained in a member to be printed. For example, in the case where a polymer in the substrate has high compatibility with a solvent contained in the conductive paint (if both have similar SP (solubility parameter) values), the solvent may penetrate the substrate and the substrate may swell, when the conductive paint is printed on the substrate. In addition, when stacked conductive layers are formed by printing, an elastomer in the first layer preferably has high compatibility with a solvent contained in the conductive paint forming the second layer. If the elastomer has poor compatibility with the solvent, wettability of the first layer with respect to the conductive paint is poor and the second layer may not be uniformly formed.

<Transducer>

A transducer of the present invention includes the flexible conductive member of the present invention. An embodiment of a capacitance sensor will be described as an example of the transducer of the present invention. In the capacitance sensor of the present embodiment, the flexible conductive member of the present invention is embodied as a wiring structure.

[Constitution of Capacitance Sensor]

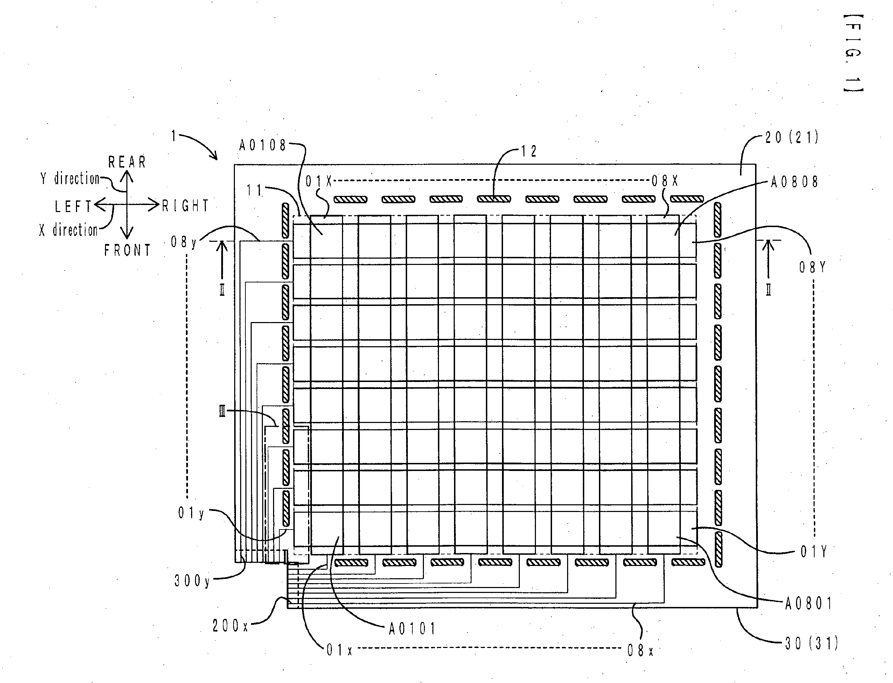

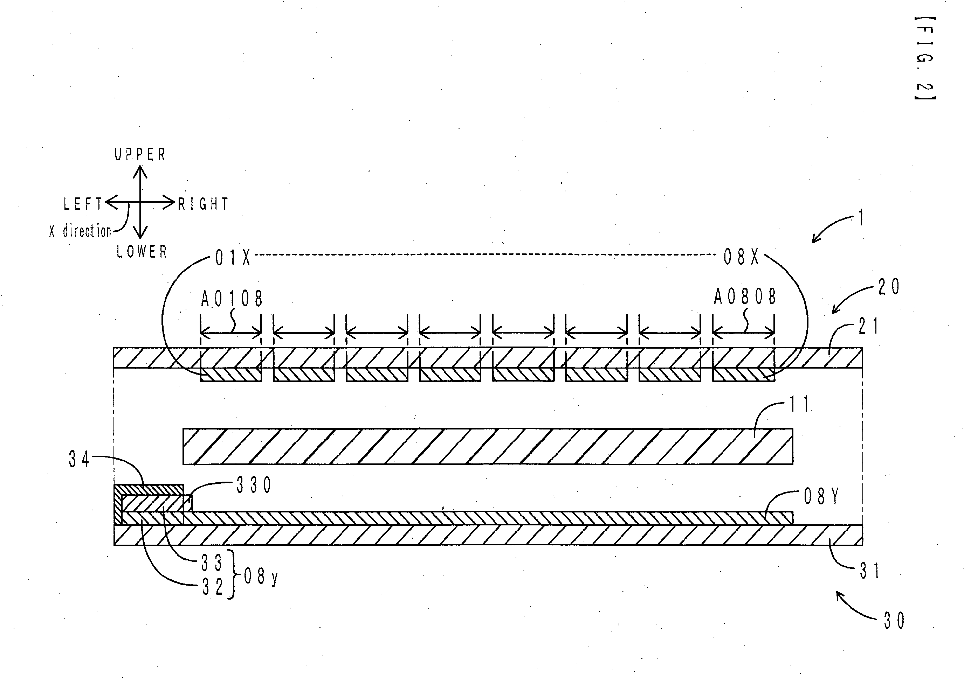

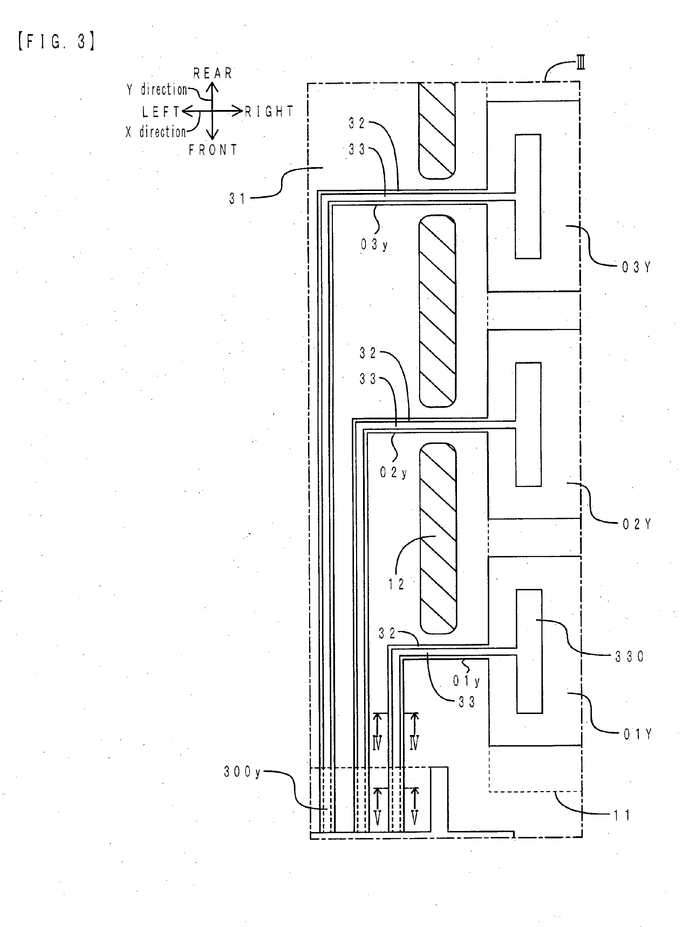

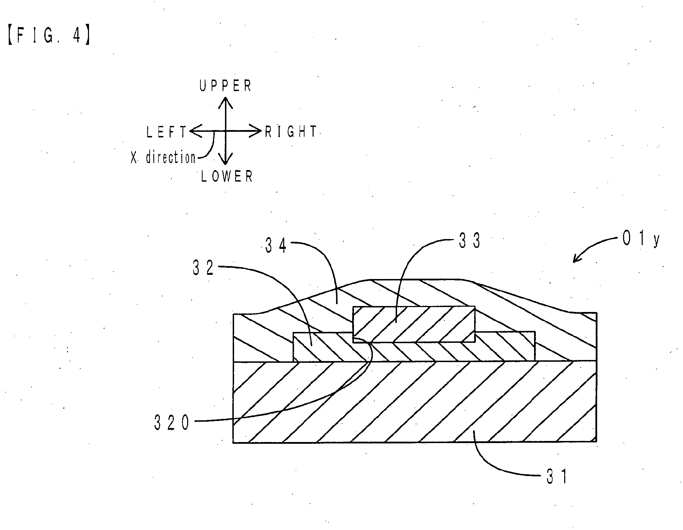

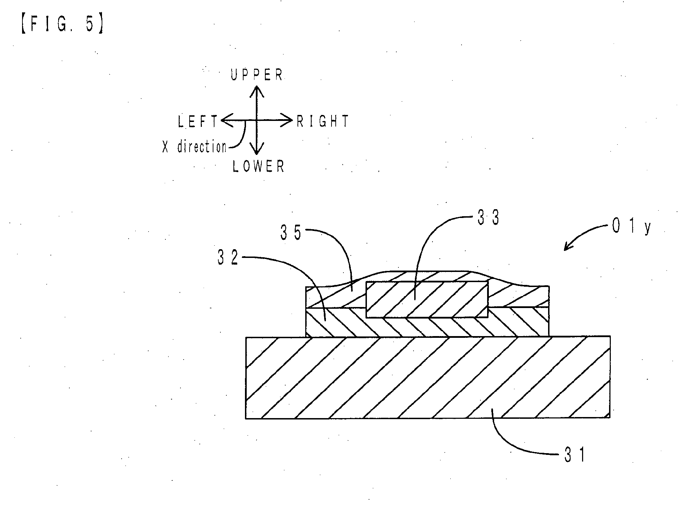

First, the constitution of the capacitance sensor of the present embodiment will be described. FIG. 1 is a perspective top view of the capacitance sensor of the present embodiment. FIG. 2 is a sectional view taken along line II-II in FIG. 1. FIG. 3 is an enlarged view of the area in frame III in FIG. 1. FIG. 4 is a sectional view taken along line IV-IV in FIG. 3. FIG. 5 is a sectional view taken along line V-V in FIG. 3. FIG. 1 shows members stacked in the front-back direction (thickness direction) in a transparent manner. In FIG. 1 and FIG. 3, a protective layer is not shown.

As shown in FIG. 1 and FIG. 2, a capacitance sensor 1 of the present embodiment includes a dielectric layer 11, a front sheet member 20, and a back sheet member 30. The dielectric layer 11 is made of a urethane foam and has a rectangular sheet shape. The dielectric layer 11 has a thickness of 300 $\mu$m. The dielectric layer 11 extends in the XY directions (left-right and front-rear directions). The front sheet member 20 and the back sheet member 30 are stacked while interposing the dielectric layer 11.

The back sheet member 30 is arranged on the lower side (back side) of the dielectric layer 11. The back sheet member 30 includes a back substrate 31, back electrodes 01Y to 08Y, and back wirings 01y to 08y. The back substrate 31 is made of polyethylene terephthalate (PET) and has a rectangular shape.

A total of eight back electrodes 01Y to 08Y are formed on the top face (front face) of the back substrate 31. Each of the back electrodes 01Y to 08Y has a strip shape. Each of the back electrodes 01Y to 08Y extends in the X direction (left-right direction). The back electrodes 01Y to 08Y are arranged at predetermined intervals in the Y direction (front-rear direction) so as to be substantially parallel to each other. Each of the back electrodes 01Y to 08Y contains acrylic rubber, carbon black, and carbon nanotube. On the top face of each left end of the back electrodes 01Y to 08Y, a terminal 330 is arranged. Each terminal 330 has a rectangular shape. A part of the terminal 330 extends in the left direction and is connected to a first conductive layer 33 of a corresponding one of the back wirings 01y to 08y described later. The terminal 330 is made of the same highly conductive material as the first conductive layer 33 and contains urethane rubber and silver powder.

A total of eight back wirings 01y to 08y are formed on the top face of the back substrate 31. Each of the back wirings 01y to 08y has a straight line shape. The back wirings 01y to 08y are connected to the corresponding left ends of the back electrodes 01Y to 08Y. In the back sheet member 30, respective stacked portions of the back substrate 31 and the back wirings 01y to 08y are included in the flexible conductive member of the present invention. As shown by the partially enlarged view in FIG. 3 and the sectional view of the back wiring 01y in FIG. 4, each of the back wirings 01y to 08y includes the first conductive layer 33, a second conductive layer 32, and a protective layer 34 except a connection end 300y.

The second conductive layer 32 is placed on the top face of the back substrate 31. The second conductive layer 32 is made of the same highly extensible conductive material as the back electrodes 01Y to 08Y and contains acrylic rubber, carbon black, and carbon nanotube. The second conductive layer 32 is formed so as to be continuous with a corresponding one of the back electrodes 01Y to 08Y. The highly extensible conductive material (second conductive layer 32) has a volume resistivity of $2.0 \times 10^{-1}$ $\Omega$·cm in an unextended condition, a volume resistivity of $7.0 \times 10^{-1}$ $\Omega$·cm at an elongation of 50%, and an elastic modulus of 20 MPa. The top face of the second conductive layer 32 has a surface roughness of 1.98 $\mu$m. The second conductive layer 32 has a width of 4 mm and a thickness of 10 $\mu$m. The top face of the second conductive layer 32 has a recess 320 extending in the longitudinal direction.

The first conductive layer 33 is stacked on the top face of the second conductive layer 32. The lower part of the first conductive layer 33 is disposed in the recess 320 of the second conductive layer 32. The first conductive layer 33 is made of a highly conductive material and contains urethane rubber and silver powder. The highly conductive material (first conductive layer 33) has a volume resistivity of $6.7 \times 10^{-5}$ $\Omega$·cm in an unextended condition, a volume resistivity of $2.0 \times 10^{-3}$ $\Omega$·cm at an elongation of 50%, and an elastic modulus of 100 MPa. The first conductive layer 33 has a width of 1 mm and a thickness of 50 $\mu$m. The first conductive layer 33 is formed so as to be continuous with the terminal 330 of a corresponding one of the back electrodes 01Y to 08Y.

The protective layer 34 is arranged on the top face of the back substrate 31 so as to cover the second conductive layer 32 and the first conductive layer 33. The protective layer 34 is made of silicone rubber.

Each front end of the back wirings 01y to 08y has a connection end 300y that is electrically connected to a measuring circuit not shown in the drawings. As shown by the sectional view of the back wiring 01y in FIG. 5, each connection end 300y includes the first conductive layer 33, the second conductive layer 32, and a reinforcement layer 35. The reinforcement layer 35 is placed on the top face of the second conductive layer 32 so as to cover the first conductive layer 33. The first conductive layer 33 is interposed between the second conductive layer 32 and the reinforcement layer 35. The reinforcement layer 35 contains a polyester resin and carbon black.

The front sheet member 20 is disposed on the upper side (front side) of the dielectric layer 11. The front sheet member 20 includes a front substrate 21, front electrodes 01X to 08X, and front wirings 01x to 08x. The front substrate 21 is made of PET and has the same rectangular shape as the back substrate 31.

A total of eight front electrodes 01X to 08X are formed on the bottom face (back face) of the front substrate 21. Each of the front electrodes 01X to 08X has a strip shape. Each of the front electrodes 01X to 08X extends in the Y direction (front-rear direction). The front electrodes 01X to 08X are arranged at predetermined intervals in the X direction (left-right direction) so as to be substantially parallel to each other. Each of the front electrodes 01X to 08X contains acrylic rubber, carbon black, and carbon nanotube. On the bottom face of each front end of the front electrodes 01X to 08X, a terminal is arranged as with the back electrodes 01Y to 08Y. A part of the terminal extend in the forward direction and is connected to a second conductive layer of the front wirings 01x to 08x described later. The terminal is made of the same highly conductive material as the front wirings 01x to 08x and contains urethane rubber and silver powder.

A total of eight front wirings 01x to 08x are formed on the bottom face of the front substrate 21. Each of the front wirings 01x to 08x has a straight line shape. The front wirings 01x to 08x are connected to the corresponding front ends of the front electrodes 01X to 08X. In the front sheet member 20, respective stacked portions of the front substrate 21 and the front wirings 01x to 08x are included in the flexible conductive member of the present invention. The constitution of the front wirings 01x to 08x is the same as the constitution of the back wirings 01y to 08y. The constitution will thus be described briefly.

Each of the front wirings 01x to 08x includes a first conductive layer, a second conductive layer, and a protective layer except a connection end 200x. The second conductive layer is arranged on the bottom face of the front substrate 21. The second conductive layer is made of the same highly extensible conductive material as the front electrodes 01X to 08X and is formed so as to be continuous with a corresponding one of the front electrodes 01X to 08X. The bottom face of the second conductive layer has a recess extending in a longitudinal direction. The first conductive layer is placed on the bottom face of the second conductive layer. The upper part of the first conductive layer is disposed in the recess of the second conductive layer. The first conductive layer has a smaller width than the second conductive layer. The first conductive layer is made of a highly conductive material and is formed so as to be continuous with the terminal of a corresponding one of the front electrodes 01X to 08X. The protective layer is arranged on the bottom face of the front substrate 21 so as to cover the first conductive layer and the second conductive layer.

Each left end of the front wirings 01x to 08x has a connection end 200x that is electrically connected to a measuring circuit not shown in the drawings. Each connection end 200x includes the first conductive layer, the second conductive layer, and a reinforcement layer. The reinforcement layer is stacked on the bottom face of the second conductive layer so as to cover the first conductive layer. The first conductive layer is interposed between the second conductive layer and the reinforcement layer.

In the peripheral area of the front sheet member 20 and the back sheet member 30, a plurality of fused portions 12 are arranged as shown by the hatching in FIG. 1. The plurality of fused portions 12 are arranged in a dotted line pattern so as to surround the dielectric layer 11. The front sheet member 20 and the back sheet member 30 are joined in the fused portions 12.

Detection portions A0101 to A0808 are arranged at the intersections (overlapping areas) of the front electrodes 01X to 08X and the back electrodes 01Y to 08Y as viewed in the vertical direction. Each of the detection portions A0101 to A0808 includes a part of a corresponding one of the front electrodes 01X to 08X, a part of a corresponding one of the back electrodes 01Y to 08Y, and a part of the dielectric layer 11. A total of 64 (eight by eight) detection portions A0101 to A0808 are arranged. The detection portions A0101 to A0808 are arranged at substantially regular intervals on substantially the entire surface of the dielectric layer 11. Load distribution is detected in a rectangular region enclosing the detection portions A0101 to A0808. Of the reference numeral of the detection portion "A○○ΔΔ", the first two digits "○○" correspond the front electrodes 01X to 08X, and the last two digits "ΔΔ" correspond to the back electrodes 01Y to 08Y.

[Production Method of Capacitance Sensor]

A method for producing the capacitance sensor 1 of the present embodiment will next be described. The method for producing the capacitance sensor 1 of the present embodiment includes a sheet member production step, a stacking step, and a fusing step.

In the sheet member production step, the following four paints are prepared, first:

(1) a second conductive paint for forming the front electrodes 01X to 08X, the back electrodes 01Y to 08Y, and the second conductive layers in the front wirings 01x to 08x and the back wirings 01y to 08y;

(2) a first conductive paint for forming the first conductive layers in the front wirings 01x to 08x and the back wirings 01y to 08y;

(3) a paint for protective layers for forming the protective layer 34; and

(4) a paint for reinforcement layers for forming the reinforcement layer 35.

Next, the prepared four paints are screen-printed appropriately on the bottom face of the front substrate 21 (bottom face in FIG. 1; the bottom face is placed so as to face upward for printing) and cured by heating, so that the front electrodes 01X to 08X and the front wirings 01x to 08x are formed. The front sheet member 20 is thus produced. In a similar manner, the prepared four paints are screen-printed appropriately on the top face of the back substrate 31 and cured by heating, so that the back electrodes 01Y to 08Y and the back wirings 01y to 08y are formed. The back sheet member 30 is thus produced.

In the stacking step, the back sheet member 30, a dielectric layer 11, and the front sheet member 20 are stacked in this order from the bottom. That is, the back sheet member 30, the dielectric layer 11, and the front sheet member 20 are stacked so that the dielectric layer 11 is interposed between the back electrodes 01Y to 08Y formed on the top face of the back substrate 31 and the front electrodes 01X to 08X formed on the bottom face of the front substrate 21.

In the fusing step, the peripheral area of the front sheet member 20 and the back sheet member 30 stacked are spot-fused at predetermined intervals (see the fused portions 12 in FIG. 1). Consequently, the capacitance sensor 1 of the present embodiment is produced.

[Movement of Capacitance Sensor]

The movement of the capacitance sensor 1 of the present embodiment will next be described. First, before a load is applied to the capacitance sensor 1 (in the initial state), a voltage is applied to the front electrodes 01X to 08X and the back electrodes 01Y to 08Y, and capacitance C is calculated for each of the detection portions A0101 to A0808. That is, the capacitance C is calculated as if the detection portions were scanned from the detection portion A0101 to the detection portion A0808. After the load is subsequently applied to the capacitance sensor 1, the capacitance C is calculated for each of the detection portions A0101 to A0808 in a similar way. In the detection portion to which the load has been applied, the distance between the front electrode and the back electrode is reduced. The detection portion accordingly has a larger capacitance C. From a change $\Delta C$ in the capacitance C, each load of the detection portions A0101 to A0808 is calculated.

[Advantageous Effects]

Advantageous effects of the capacitance sensor 1 of the present embodiment will next be described. The wirings of the capacitance sensor 1 of the present embodiment are made of the flexible conductive member of the present invention. That is, each of the back wirings 01y to 08y formed on the top face of the back substrate 31 includes the first conductive layer 33 and the second conductive layer 32. Similarly, each of the front wirings 01x to 08x formed on the bottom face of the front substrate 21 includes the first conductive layer and the second conductive layer. The first conductive layer 33 is formed of a highly conductive material, and the second conductive layer 32 is formed of a highly extensible conductive material. In a natural condition (unextended condition), electricity passes mainly through the first conductive layer 33, and thus the wirings have a small electrical resistance. In an extended condition, electricity passes mainly through the second conductive layer 32, and thus the wirings have a small electrical resistance. In this manner, in the front wirings 01x to 08x and the back wirings 01y to 08y, an advantageous conductive pathway can be selected in accordance with the conditions, and thus the wirings can maintain an intended electric conductivity both in a natural condition and an extended condition. The wirings thus have an electrical resistance that is less likely to increase even when extension and contraction are repeated.

In addition, the first conductive layer 33 and the second conductive layer 32 are arranged in a stacked manner, and thus the conductive layers provide the reinforcing effect. Thus, the front wirings 01x to 08x and the back wirings 01y to 08y have excellent durability against extension and contraction. The top face (face on which the first conductive layer 33 is stacked) of the second conductive layer 32 arranged on the back substrate 31 has a surface roughness of 1.98 μm. The surface roughness value is about 1/5 the thickness of the second conductive layer 32. On this account, the adhesion force between the first conductive layer 33 and the second conductive layer 32 is large. Thus, the first conductive layer 33 is less likely to delaminate from the second conductive layer 32 even when extension and contraction are repeated. In the embodiment, the substrate, the second conductive layer, and the first conductive layer are stacked in this order, but the layers may be stacked in the reverse order, or the substrate, the first conductive layer, and the second conductive layer may be stacked in this order.

Each of the front wirings 01x to 08x and the back wirings 01y to 08y includes the protective layer 34 made of silicone rubber except the connection end 200x, 300y. On this account, the silver powder contained in the first conductive layer 33 is less likely to be oxidized. Thus, the first conductive layer 33 has an electric conductivity that is less likely to deteriorate even when the capacitance sensor 1 is used for a long period of time. The protective layer 34 covering the wirings can secure insulation from outside. The protective layer 34 is also expected to provide reinforcing effect for the front wirings 01x to 08x and the back wirings 01y to 08y. In the connection ends 200x, 300y, each of the front wirings 01x to 08x and the back wirings 01y to 08y includes the reinforcement layer 35 containing carbon black. This increases the strength of the connection ends 200x, 300y to improve the durability. Thus, the capacitance sensor 1 has a performance that is less likely to deteriorate due to the electrodes or the wirings. The capacitance sensor 1 therefore has excellent durability. Examples

The present invention will next be described in further detail with reference to Examples.

<Preparation of First Conductive Paint A>

A first conductive paint A was prepared as follows. First, 100 parts by mass of a urethane rubber polymer ("VYLON (registered trademark) BX1001" manufactured by Toyobo Co., Ltd.) was dissolved in butyl carbitol acetate serving as a solvent. To the urethane rubber solution, 400 parts by mass of silver powder ("Ag-XF301" manufactured by Fukuda Metal Foil & Powder Co.) was added, and the whole was stirred.

<Preparation of Second Conductive Paints B to D>

A second conductive paint B was prepared as follows. First, 100 parts by mass of an acrylic rubber polymer ("Nipol (registered trademark) AR42W" manufactured by ZEON CORPORATION) and 0.1 part by mass of ethylenediamine serving as a crosslinking agent were mixed with a roll mill to prepare an acrylic rubber composition. The prepared acrylic rubber composition was dissolved in butyl carbitol acetate to prepare an acrylic rubber solution. To the acrylic rubber solution, 20 parts by mass of carbon nanotube ("VGCF (registered trademark)" manufactured by Showa Denko K. K.) and 17 parts by mass of carbon black ("Ketjenblack EC300JD" manufactured by Ketjenblack International) were added, and the whole was stirred. Separately, second conductive paints C and D were prepared in the same manner as the second conductive paint B except that the amounts of the carbon nanotube and the carbon black were changed.

<Measurement of Physical Properties and Surface Roughness of Conductive Layer>

Each conductive paint prepared was printed on a substrate (release PET film) by bar coating to produce conductive layers A to D. The first conductive layer A is made of a highly conductive material. The second conductive layers B to D are made of a highly extensible conductive material. The elastic modulus, the elongation at break, the volume resistivity in an unextended condition, the volume resistivity at an elongation of 50%, and the surface roughness of each conductive layer were determined. The measurement methods were as below. Table 1 shows the formulation and the measurement results of physical properties and other properties of each conductive layer. In Table 1, the unit of the amounts of raw materials is parts by mass.

[Elastic Modulus]

Tensile test was carried out in accordance with JIS K7127 (1999), and an elastic modulus was calculated from the obtained stress-elongation curve. The test piece used was type 2.

[Elongation at Break]

Tensile test was carried out in accordance with JIS K6251 (2010), and the elongation at break ($E_b$) was calculated. A test piece having the shape of dumbbell No. 5 was used, and the elongation rate was 100 mm/min.

[Volume Resistivity]

The volume resistivity was determined in accordance with parallel terminal electrode method in JIS K6271 (2008). The distance between electrodes was 10 mm in an unextended condition. The insulating resin holder used for holding a test piece was a commercially available silicone rubber sheet (manufactured by KUREHA ELASTOMER Co., Ltd.).

[Surface Roughness]

The surface roughness was determined from an SEM photograph of a cross section of a conductive layer in accordance with Equation (1) above.

[Table 1]

| | | | First conductive layer A | Second conductive layer B | Second conductive layer C | Second conductive layer D |
|---|---|---|---|---|---|---|
| Raw material | Elastomer | Urethane rubber | 100 | - | - | - |
| | | Acrylic rubber | - | 100 | 100 | 100 |
| | Conductive agent | Silver powder | 400 | - | - | - |
| | | Carbon nanotube | - | 20 | 11 | 23 |
| | | Carbon black | - | 17 | 9.4 | 19.6 |
| | Crosslinking agent | Ethylenediamine | - | 0.1 | 0.1 | 0.1 |
| Physical properties | Elastic modulus [MPa] | | 100 | 20 | 11 | 43 |
| | Elongation at break [%] | | 100 | 50 | 61 | 50 |
| | Volume resistivity in unextended condition [$\Omega \cdot$cm] | | $6.7 \times 10^{-5}$ | $2.0 \times 10^{-1}$ | $1.0 \times 10^{0}$ | $1.0 \times 10^{-1}$ |
| | Volume resistivity at 50% elongation [$\Omega \cdot$cm] | | $2.0 \times 10^{-3}$ | $7.0 \times 10^{-1}$ | $1.8 \times 10^{0}$ | $6.0 \times 10^{-1}$ |
| Surface roughness [$\mu$m] | | | 1.10 | 1.98 | 1.87 | 2.11 |

flexible conductive member. The substrate used was a urethane elastomer sheet. The first conductive layer formed from the first conductive paint A had a width of 2 mm, a length of 20 mm, and a thickness of 25 $\mu$m. The second conductive layer formed from any of the second conductive paints B to D had a width of 10 mm, a length of 20 mm, and a thickness of 10 $\mu$m. The flexible conductive members of Examples 1 to 4 are included in the flexible conductive member of the present invention.

[Example 1]

A flexible conductive member including a substrate, a first conductive layer A, and a second conductive layer B was produced as follows. First, on the top face of a substrate, the first conductive paint A was screen-printed. The coating formed from the first conductive paint A was pre-dried to be brought into a semi-cured state. Next, on the top face of the semi-cured coating of the first conductive paint A, the second conductive paint B was screen-printed. The formed coating was cured by heating to form two conductive layers A and B.

[Example 2]

A flexible conductive member including the substrate, the second conductive layer B, and the first conductive layer A was produced with the printing order of the conductive paints changed. The method of forming the conductive layers is the same as in Example 1.

[Example 3]

A flexible conductive member including the substrate, the second conductive layer C, and the first conductive layer A was produced using the second conductive paint C instead of the second conductive paint B in Example 2.

[Example 4]

A flexible conductive member including the substrate, the second conductive layer D, and the first conductive layer A was produced using the second conductive paint D instead of the second conductive paint B in Example 2.

[Comparative Example 1]

The second conductive paint B was screen-printed on the top face of a substrate, and the coating was cured by heating to produce a flexible conductive member including the substrate and the second conductive layer B.

[Comparative Example 2]

The first conductive paint A was screen-printed on the top face of a substrate, and the coating was cured by heating to produce a flexible conductive member including the substrate and the second conductive layer A.

[Comparative Example 3]

The first conductive paint A was screen-printed on the top face of a substrate. The coating formed from the first conductive paint A was pre-dried to be brought into a semi-cured state. Next, on the top face of the semi-cured coating of the first conductive paint A, a carbon paste ("JELCON CH-8" manufactured by Jujo Chemical Co., Ltd.) was screen-printed. The formed coating was cured by heating to form two conductive layers. The conductive layer formed from the carbon paste had a volume resistivity of $1.0 \times 10^{-2}$ $\Omega$·cm in an unextended condition. The conductive layer had an elastic modulus of 1,200 MPa and was broken at an elongation of 50%. Thus, the conductive layer as the upper layer is not included in the second conductive layer of the present invention.

<Measurement of Electrical Resistance>

A terminal was attached to each end of the upper conductive layer in the longitudinal direction, and the electrical resistance in an unextended condition and the electrical resistance at an elongation of 50% after extension and contraction durability test were determined. The extension and contraction durability test was carried out as follows. First, both ends of a flexible conductive member were gripped with a pair of jigs. Next, one of the jigs was fixed, and the other was reciprocated at a speed of 50 mm/min so that the flexible conductive member extended and contracted. The elongation ratio of the flexible conductive member was 50%, and the number of extensions and contractions was 7,000. Table 2 shows the test results.

[Table 2]

| | Example 1 | Example 2 | Example 3 | Example 4 | Comparative Example 1 | Comparative Example 2 | Comparative Example 3 |
|---|---|---|---|---|---|---|---|
| Constitution of flexible conductive member | Second conductive layer B | First conductive layer A | First conductive layer A | First conductive layer A | - | - | Carbon paste |
| | First conductive layer A | Second conductive layer B | Second conductive layer C | Second conductive layer D | Second conductive layer B | First conductive layer A | First conductive layer A |
| | Substrate | Substrate | Substrate | Substrate | Substrate | Substrate | Substrate |
| Electrical resistance in unextended condition [$\Omega$] | $5.5 \times 10^{-1}$ | $7.0 \times 10^{-1}$ | $5.1 \times 10^{-1}$ | $3.0 \times 10^{-1}$ | $5.0 \times 10^{2}$ | $8.0 \times 10^{-1}$ | $7.0 \times 10^{-1}$ |
| Electrical resistance at 50% elongation after 7,000 times repetition of extension and contraction [$\Omega$] | $9.0 \times 10^{3}$ | $3.5 \times 10^{3}$ | $5.8 \times 10^{3}$ | $4.2 \times 10^{3}$ | $7.0 \times 10^{3}$ | $9.0 \times 10^{10}$ | $8.6 \times 10^{10}$ |

As shown in Table 2, each of the flexible conductive members of Examples 1 to 4, which included the first conductive layer and the second conductive layer, had a small electrical resistance in the initial state (unextended). Further, in each of the flexible conductive members of Examples 1 to 4, the electrical resistance at an elongation of 50% after the extension and contraction were repeated 7,000 times was $10^5$ times or less the volume resistivity in the initial state. In contrast, the flexible conductive member of Comparative Example 1, which included the second conductive layer alone, had a small increase in the electrical resistance at an elongation of 50% after the extension and contraction were repeated 7,000 times. However, the flexible conductive member of Comparative Example 1 had a large electrical resistance in the initial state and thus is unsuitable for electrodes or wirings. The flexible conductive member of Comparative Example 2, which included the first conductive layer alone, had a small electrical resistance in the initial state but had a markedly higher electrical resistance at an elongation of 50% after the extension and contraction were repeated 7,000 times. Similarly, the flexible conductive member of Comparative Example 3, which included no second conductive layer, also had a small electrical resistance in the initial state but had a markedly higher electrical resistance at an elongation of 50% after the extension and contraction were repeated 7,000 times.

The above results reveal that the flexible conductive member of the present invention including the first conductive layer and the second conductive layer has high electric conductivity in a natural condition and has a small decrease in the electric conductivity even when extension and contraction are repeated. In the examples, butyl carbitol acetate was used as the solvent in the first conductive paint and the second conductive paint. The compatibility of butyl carbitol acetate and acrylic rubber is high, but the compatibility of butyl carbitol acetate and urethane rubber is not so high. In consideration of the compatibility of an elastomer in the first layer and a solvent contained in the conductive paint constituting the second layer, the flexible conductive members of Examples 2 to 4 including the substrate, the second conductive layer (acrylic rubber), and the first conductive layer (urethane rubber) in this order are preferred in the examples.

INDUSTRIAL APPLICABILITY

The flexible conductive member of the present invention is suitably used as electrodes and wirings for flexible transducers including elastomers. The flexible conductive member is also suitable as wirings of flexible wiring boards used for flexible displays and as electrodes and wirings of wearable devices and control devices for moving parts of robots and industrial machines. The flexible conductive member can also be used as electrically conductive adhesives and electromagnetic wave shields. In motors and actuators driven by electromagnetic force and speakers, vibrators, ultrasonic generators, and the like using piezoelectric effect, repeated vibration may break wirings. The flexible conductive member of the present invention is applicable to sections requiring durability against repeated vibration in a wide frequency range regardless of the magnitude of displacement.

**Claims**

1.   A flexible conductive member **characterized by** comprising:

an elastic substrate; and
a plurality of conductive layers arranged on a surface of the substrate in at least one of a stacked manner and a parallel manner, wherein
the conductive layers include: a first conductive layer including a highly conductive material that contains an elastomer and a conductive agent and has a volume resistivity of $5 \times 10^{-2}$ $\Omega \cdot$cm or less in an unextended condition; and a second conductive layer including a highly extensible conductive material that has a volume resistivity in an unextended condition larger than the volume resistivity of the highly conductive material in an unextended condition, contains an elastomer and a conductive agent, and has a change in volume resistivity at an elongation of 50% relative to an unextended condition of 10 times or less.

2.   The flexible conductive member according to claim 1, wherein
a difference between the volume resistivity of the highly conductive material in an unextended condition and the volume resistivity of the highly extensible conductive material in an unextended condition is five digits or less.

3.   The flexible conductive member according to claim 1 or 2, wherein
the highly extensible conductive material has an elastic modulus of 50 MPa or less.

4.   The flexible conductive member according to any one of claims 1 to 3, wherein
the conductive agent contained in the highly extensible conductive material is an electrically conductive carbon powder.

5.  The flexible conductive member according to any one of claims 1 to 4, wherein
    the conductive agent contained in the highly conductive material is a metal powder.

6.  The flexible conductive member according to any one of claims 1 to 5, wherein
    the first conductive layer and the second conductive layer are stacked.

7.  The flexible conductive member according to claim 6, wherein
    out of the first conductive layer and the second conductive layer, the conductive layer arranged on the substrate
    has a surface roughness of 1/200 or more and twice or less the thickness of the conductive layer.

8.  The flexible conductive member according to claim 6 or 7, wherein
    the second conductive layer is arranged on the surface of the substrate, and the first conductive layer is arranged
    on a surface of the second conductive layer.

9.  A transducer **characterized by** comprising:

    the flexible conductive member as claimed in any one of claims 1 to 8.

[FIG. 1]

EP 2 924 695 A1

15

[F I G. 2]

[FIG. 3]

[FIG. 4]

UPPER

LEFT ⟵　　⟶ RIGHT

X direction

LOWER

[FIG. 5]

UPPER

LEFT ←——→ RIGHT

X direction

LOWER

## INTERNATIONAL SEARCH REPORT

| International application No. |
| --- |
| PCT/JP2012/080158 |

A. CLASSIFICATION OF SUBJECT MATTER
*H01B5/14*(2006.01)i, *G01L1/14*(2006.01)i, *G01L5/00*(2006.01)i, *H04R19/00*
(2006.01)i, *H05K1/09*(2006.01)i

According to International Patent Classification (IPC) or to both national classification and IPC

B. FIELDS SEARCHED

Minimum documentation searched (classification system followed by classification symbols)
H01B5/14, G01L1/14, G01L5/00, H04R19/00, H05K1/09

Documentation searched other than minimum documentation to the extent that such documents are included in the fields searched
Jitsuyo Shinan Koho          1922-1996   Jitsuyo Shinan Toroku Koho   1996-2013
Kokai Jitsuyo Shinan Koho    1971-2013   Toroku Jitsuyo Shinan Koho   1994-2013

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | WO 2012/050128 A1  (Tokai Rubber Industries, Ltd.), 19 April 2012 (19.04.2012), entire text; all drawings (Family: none) | 1-9 |
| A | JP 2010-153821 A  (Tokai Rubber Industries, Ltd.), 08 July 2010 (08.07.2010), entire text; all drawings (Family: none) | 1-9 |
| A | JP 2012-138260 A  (Tokai Rubber Industries, Ltd.), 19 July 2012 (19.07.2012), entire text; all drawings (Family: none) | 1-9 |

[X]  Further documents are listed in the continuation of Box C.          [ ]  See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search 13 February, 2013 (13.02.13) | Date of mailing of the international search report 26 February, 2013 (26.02.13) |
| --- | --- |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/080158

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2012-33674 A  (Tokai Rubber Industries, Ltd.), 16 February 2012 (16.02.2012), entire text; all drawings (Family: none) | 1-9 |
| A | WO 2011/145411 A1  (Tokai Rubber Industries, Ltd.), 24 November 2011 (24.11.2011), entire text; all drawings & EP 2450911 A1          & CN 102483972 A | 1-9 |

Form PCT/ISA/210 (continuation of second sheet) (July 2009)

**EP 2 924 695 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010153821 A
- JP 2011075322 A
- JP 2005317638 A
- JP 6194680 A